Europäisches Patentamt

European Patent Office

Office européen des brevets

(11) Veröffentlichungsnummer: **0 355 695**
**A2**

## (12) EUROPÄISCHE PATENTANMELDUNG

(21) Anmeldenummer: 89115115.1

(22) Anmeldetag: 16.08.89

(51) Int. Cl.⁴: **H05K 9/00**

(30) Priorität: 26.08.88 DE 8810813 U

(43) Veröffentlichungstag der Anmeldung:
28.02.90 Patentblatt 90/09

(84) Benannte Vertragsstaaten:
**AT BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Haas, Hans, Dipl.-Ing. (FH)**
**Rothenburger Strasse 5**
**D-8501 Grosshabersdorf(DE)**

(54) **Zylinderförmiger Wabenkamineinsatz zur elektromagnetisch abgeschirmten Be- und Entlüftung, Beleuchtung oder Beschallung.**

(57) Ein zylinderförmiger Wabenkamin besteht aus ringförmig geschlossenen, segmentartig übereinanderliegenden Wabenketten (WK1...WK4). Gemäß einer vorteilhaften Ausführungsform sind Wabenketten (WK1,WK2) im Inneren des von einem äußeren zylindrischen Rahmen (ZR3) abgeschlossenen Wabenkamins zusätzlich von weiteren Zylinderringen (ZR1,ZR2) umgeben. Vorteilhaft verfügt desweiteren eine außerhalb eines derartigen Zylinderringes (ZR1 bzw. ZR2) liegende Wabenkette (WK2 bzw. WK3) über die doppelte Anzahl an Waben (W21,W22,W23 bzw.W31,W32,W33) im Vergleich zu der jeweils vom Zylinderring umgebenen Wabenkette (WK1 bzw.WK2). Schließlich sind die ringförmigen Wabenketten (WK1 und WK2) vorteilhaft so verdreht zueinander angeordnet, daß in radialer Richtung je eine Wabe (W11) einer inneren Kette (WK1) und eine Wabe (W21) der äußeren Kette (WK2) mittels des jeweils dazwischenliegenden Zylinderringes (ZR1) über eine gemeinsame Kontaktstelle (K2) verfügt.

FIG 1

## Zylinderförmiger Wabenkamineinsatz zur elektromagnetisch abgeschirmten Be- und Entlüftung, Beleuchtung oder Beschallung

Die Erfindung betrifft einen zylinderförmigen Wabenkamin, insbesondere zum Einsatz in Wänden und Decken von elektromagnetisch abgeschirmten Räumen, Kabinen oder Gebäuden, welcher eine elektromagnetisch abgeschirmte Be- und Entlüftung, Beleuchtung oder Beschallung ermöglicht, und die Merkmale des Oberbegriffes von Anspruch 1 enthält.

Bei elektromagnetisch abgeschirmten Räumen, Kabinen oder Gebäuden ist es in der Regel nicht möglich, diese nach außen hin vollständig hermetisch abzudichten. Um den Aufenthalt von Personen bzw. den Betrieb von in der Regel elektrische Verlustwärme erzeugenden elektrischen und/oder mechanischen Geräten in einem derartigen elektromagnetisch abgeschirmten Raum zu ermöglichen ist es häufig notwendig, insbesondere zur Be- und Entlüftung, Beleuchtung oder Beschallung einen direkten, vorzugsweise auch den Druckausgleich zulassenden Kontakt zwischen dem Inneren des elektromagnetisch abgeschirmten Raumes und der nicht abgeschirmten Umgebung herzustellen. Dennoch darf hierdurch die Güte der elektromagnetischen Abschirmung des jeweiligen Raumes, der Kabine bzw. des Gebäudes möglichst nicht beeinträchtigt werden, d.h. es dürfen sich hierdurch keine Schwachstellen in der elektromagnetischen Abschirmung ergeben.

Zur elektromagnetischen Abdichtung insbesondere von Fensteröffnungen und den Anschluß von Luftführungsrohren von Klimaanlagen ermöglichenden Zu- und Abluftöffnungen ist es bekannt, sogenannte Wabenkamineinsätze vorzusehen. Diese bestehen aus einem rechteckigen Rahmenelement, dessen Öffnung vollständig mit jeweils einen Hohlraum bildenden Waben aus leitfähigem Material ausgefüllt ist. Diese Waben sind dabei derart miteinander und mit dem Rahmen leitend kontaktiert, daß sich eine Vielzahl von kettenartig in parallelen, versetzen Reihen angeordneten, wabenförmigen Öffnungen ergibt. Dabei steht die maximal zulässige Breite einer Wabe zur Größe der jeweils vorliegenden Wabentiefe in einem vom Wert der gegenüber elektromagnetischen Wellen in einem bestimmten Frequenzbereich gewünschten Dämpfung abhängigen Verhältnis. Desweiteren müssen alle Waben untereinander und mit dem das Wabenpaket umgebenden äußeren Rahmen über die gesamte Wabentiefe vollständig leitend kontaktiert sein.

Der Erfindung liegt die Aufgabe zugrunde, einen zylinderförmigen Wabenkamineinsatz zur elektromagnetischen Abschirmung von insbesondere zur Be- und Entlüftung, Beleuchtung oder Beschallung dienenden Öffnung in den Wänden und Decken von elektromagnetisch abgeschirmten Räumen, Kabinen oder Gebäuden anzugeben.

Die Aufgabe wird gelöst mit einem Wabenkamin mit den Merkmalen von Schutzanspruch 1. Weitere vorteilhafte Ausführungsformen der Erfindung sind in den Unteransprüchen angegeben.

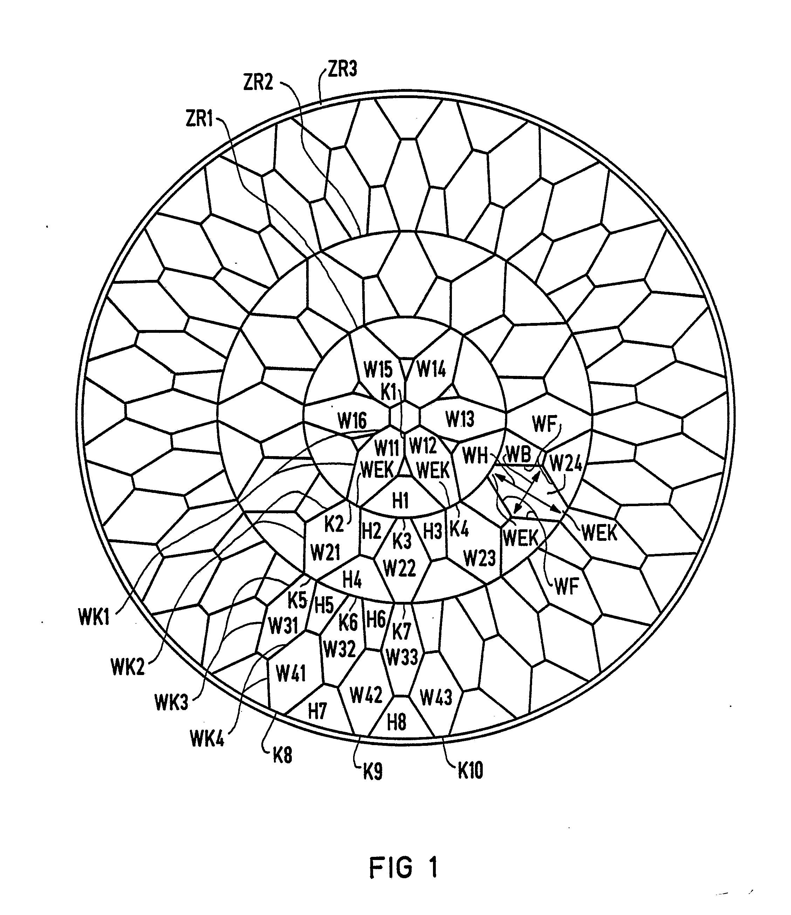

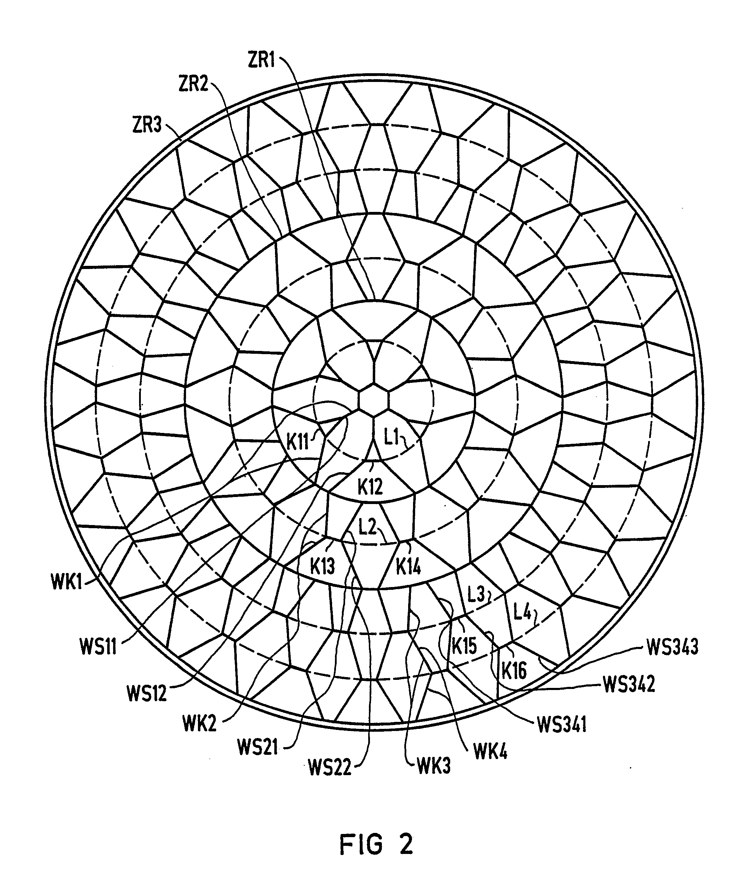

Die Erfindung wird desweiteren anhand der Figuren 1 und 2 näher erläutert, welche eine vorteilhafte Ausführungsform eines gemäß der Erfindung aufgebauten zylinderförmigen Wabenkamins darstellen.

Gemäß der Erfindung werden zur Bildung eines zylinderförmigen Wabenkamins die kettenartig hintereinander angeordneten Waben desweiteren Wabenketten genannt, ringförmig geschlossen und segmentartig übereinanderliegend miteinander und mit einem die ringförmig Wabenketten nach außen abschließenden zylindrischen Rahmen elektrisch leitend kontaktiert. Die Anzahl der Waben in jeder ringförmigen Kette wird dabei so groß gewählt, daß die Breite der Waben in allen segmentartig übereinanderliegenden und den zylinderförmigen Wabenkamin bildenden Wabenketten annähernd gleich groß ist.

In einer weiteren vorteilhaften Ausführungsform des erfindungsgemäßen zylinderförmigen Wabenkamins wird eine im Inneren der segmentartig übereinanderliegenden ringförmig geschlossenen Wabneketten liegende Wabenkette von einem weiteren Zylinderring umgeben und elektrisch leitend kontaktiert. Dies ist insbesondere dann von Vorteil, wenn aufgrund der Krümmung auf der außenliegenden Seite der Wabenkette sich gegenüber der nach außen anschließenden Wabenkette Öffnungen ergeben, deren Breite und Form erheblich von der gewünschten mittleren Breite und Form der Waben im gesamten zylinderförmigen Wabenkamineinsatz abweicht.

Die in der FIG 1 und 2 dargestellte vorteilhafte Ausführungsform eines zylinderförmigen Wabenkamins gemäß der Erfindung besteht beispielhaft aus den vier segmentartig übereinanderliegenden, ringförmig geschlossenen Wabenketten WK1, WK2, WK3 und WK4. Dabei besteht die innerste Wabenkette WK1 aus den sechs Waben W11 bis W16. Diese Wabenkette wird segmentförmig von den weiteren Wabenketten WK2, WK3, WK4 umgeben, bei denen beispielhaft die Waben W21, W22, W23, W24 bzw. W31, W32, W33 bzw. W41, W42, W43 näher gekennzeichnet sind. Man erkennt, daß gemäß der Erfindung die Anzahl der Waben in den weiter außenliegenden ringförmigen Wabenketten größer ist als in den weiter innenliegenden Wabenketten. So verfügt beispielsweise die Wabenkette WK2 über eine größere Anzahl von Waben als die Kette WK1. Entsprechend verfügen die Wabenketten WK3 und WK4 über eine größere Anzahl an Waben als die weiter innenliegenden Wabenkette WK2. Gemäß der Erfindung wird die Anzahl der Waben in jeder Kette so groß gewählt, daß die mittlere Breite WB aller Waben, welche in der Wabe W24 der Wabenkette WK2 beispielhaft eingetragen ist, der in der FIG 1 dargestellten Gesamtstruktur annähernd gleich groß ist. In dem in der FIG 1 dargestellten vorteilhaften Ausführungsbeispiel verfügen die beiden Wabenketten WK3 und WK4 über die gleiche Anzahl von Waben, da aufgrund ihrer Lage im Außenbereich des zylinderförmigen Wabenkamins die Abweichung der jeweiligen tatsächlichen Wabenbreite von der gewünschten mittleren Waben breite nur gering ist. Würde dagegen die in der FIG 1 am weitesten außenliegende Wabenkette WK4 beispeilsweise von einer weiteren, nicht dargestellten Wabenkette ringförmig umgeben sein, so wäre es zur Einhaltung der mittleren Wabenbreite vorteilhaft, wenn diese weitere Wabenkette wiederum über eine größere Anzahl an Waben verfügen würde als die beiden innenliegenden Wabenketten WK3 und WK4.

Der aus den vier ringförmigen Wabenketten WK1 bis WK4 bestehende zylinderförmige Wabenkamin gemäß der Ausführungsform von FIG 1 bzw. 2 wird nach außen von einem insbesondere einen Zylinderring bildenden zylindrischen Rahmen ZR3 abgeschlossen. Entsprechend der bereits angeführten, weiteren vorteilhaften Ausführungsform der Erfindung sind im Inneren des Wabenkamins von FIG 1 beispielhaft zwei weitere Zylinderringe ZR1 und ZR2 vorhanden. Dabei umschließt der Zylinderring ZR1 die innerste Wabenkette WK1, und ist elektrisch leitend an allen Kontaktstellen mit der innenliegenden Wabenkette Wk1 und der umgebenden Wabenkette WK2 kontaktiert. Im Ausführungsbeispiel der FIG 1 sind hierzu beispielhaft die Kontaktstellen K2, K3 und K4 der Wabenketten WK1 und WK2 mit dem Zylinderring ZR1 dargestellt. In entsprechende Weise umgibt der Zylinderring ZR2 die Wabenkette WK2, und ist wiederum an allen möglichen Kontaktstellen mit der innenliegenden Wabenkette WK2 und der umgebenden Wabenkette WK3 elektrisch leitend kontaktiert. In der FIG 1 sind hierzu beispielhaft die Kontakstellen K5, K6 und K7 der Wabenketten WK2 und WK3 mit dem Zylinderring ZR2 dargestellt. In der gleichen Weise ist in der FIG 1 die am weitesten außenliegende Wabenkette WK4 von dem als Abschlußrahmen dienenden Zylinderring ZR3 umgeben und mit diesem unter anderen an den beispielhaft dargestellten Kontakstellen K8, K9 und K10 elektrisch leitend kontaktiert.

Gemäß der Erfindung haben diese Zylinderringe den besonderen Vorteil, daß die sich zwischen der Zylinderinnenseite und der außenliegenden Seite der vom Zylinder umgebenden Wabenkette ergeben den Öffnungen über eine Querschnittsfläche verfügen, welche annähernd der mittleren Querschnittsfläche der Waben im Wabenkamin entspricht. Desweiteren verfügen diese Öffnungen vorteilhaft über eine Breite, welche in der Regel die maximal zulässige mittlere Breite der Waben im Wabenkamin nicht überschreitet. Je nach Anwendungsfall kann dabei als Wabenbreite entweder die in der FIG 1 am Beispiel der Wabe W24 eingetragene radiale Ausdehnung WB einer Waben dienen. Es ist demgegenüber auch denkbar, als Maß für die Wabenbreite den sich innerhalb einer Wabe ergebenden ·größtmöglichen Abstand zwischen den Wabenwänden heranzuziehen.

So ist in der in FIG 1 und 2 dargestellten Ausführungsform eines Wabenkamins beispielsweise die Krümmung der innersten Wabenkette WK1 so groß, daß sich die innenliegenden Wabenflanken WF der die Wabenkette bildenden Waben berühren. In der FIG 1 ist ein derartiger Kontaktpunkt K1 zwischen den Waben W11 und W12 der Kette WK1 beispielhaft eingetragen. Aufgrund dieser Krümmung würde beispielsweise auf der Außenseite der Waben W11, W12 der Kette WK1 gegenüber der Innenseite der Waben W21, W22, W23 der sich in radialer ·Richtung anschließenden Wabenkette WK2 eine sehr große, aus den Hohlräumen H1, H2 und H3 gebildete Öffnung entstehen. Der näherungsweise hufeisenförmige Querschnitt einer derartigen Öffnungen würde zum einen sehr stark von der gewünschten wabenförmigen Struktur der Öffnungen im Wabenkamin abweichen. Desweiteren würde der sich zwischen den diese Öffnung begrenzenden Wänden ergebende größtmögliche Abstand die gewünschte mittlere Breite der Waben des Wabenkamins erheblich überschreiten. Wird dagegen gemäß der Erfindung einer derart gekrümmte Wabenkette von einem Zylinderring umgeben, so teilt sich beispielsweise die im Querschnitt hufeisenförmige Öffnung zwischen den Waben W11, W12 und W21, W22, W23 in die drei erheblich kleineren Öffnungen H1, H2 und H3 auf. Entsprechend wird die im Querschnitt hufeisenförmige Öffnung zwischen den Waben W21, W22 der kette WK2 und den Waben W31, W32, W33 der Kette WK3 durch den Zylinderring ZR2 in die einzelnen Öffnungen H4, H5 und H6 auf geteilt. Dies hat zum einen den besonderen Vorteil, daß die sich so ergebenden Öffnungen H1 bis H6 im Querschnitt erheblich kleiner bzw. zumindest nicht größer als die Waben der Wabenketten des Wabenkamins sind. Zum anderen wird die mechanische Festigkeit des beispielsweise aus den vier Wabenketten WK1 bis WK4 aufgebauten Wabenkamins entsprechend der FIG 1 durch das Einbringen der zusätzlichen Zylinderringe ZR1 und ZR2 erheblich verbessert. Dies hat seine Ursache darin, daß beispielsweise das innenliegende Ende der Wabe W22 der Kette WK2 nun über den Kontaktpunkt K3 mit dem Zylinderring ZR1 zusätzlich mechanisch mit den in der Kette jeweils benachbarten Waben W21 und W23 insbesondere über die Kontaktbunde K2 und K4 sowohl mechanisch als auch elektrisch leitend kontaktiert ist. Entsprechend ergibt sich beispielsweise für das innenliegende Ende der Wabe W32 der Kette WK3 über den Kontaktpunkt K6 mit dem Zylinderring ZR2 eine besonders vorteilhafte, zusätzliche mechanische und elektrisch leitende Verbindung mit den benachbarten Waben W31 und W33 über die Kontaktpunkt K5 und K7.

Gemäß einer weiteren vorteilhaften Ausführungsform der Erfindung verfügt eine auf der Außenseite eines Zylinderringes kontaktierte äußere Wabenkette im Vergleich zu der vom Zylinderring umgebenen inneren Wabenkette über die doppelte Anzahl an Waben. Dies ist bereits in der Ausführungsform von FIG 1 und 2 am Beispiel der Wabenkette WK1, WK2 und WK3 bzw. WK4 dargestellt. So verfügt zum einen die Wabenkette WK2 im Vergleich zur Kette WK1 über die doppelte Anzahl an Waben. Entsprechend weisen jeweils die Ketten WK3 und WK4 im Vergleich zur Kette WK2 die doppelte Anzahl an Waben auf. Desweiteren ist es besonders vorteilhaft, wenn zu dem die auf der Außenseite eines Zylinderringes kontaktierte und über die doppelte Anzahl von Waben verfügende äußere Wabenkette gegenüber der vom Zylinderring umgebenen inneren Wabenkette so verdreht angeordnet ist, daß in raidaler Richtung gesehen die außenliegenden Endkanten einer jeden Waben der inneren Kette über den Zylinderring als Kontakstelle direkt der innenliegenden Endkante einer Wabe der äußeren Kette gegenüberliegen. Auch dies ist bereits anhand der Ausführungsform von FIG 1 und 2 dargestellt. So sind beispielsweise die beiden Ketten WK1 und WK2 zueinander so verdreht angeordnet, daß beispielsweise die außenliegenden Endkanten WEK der Waben W11, W12 der Kette WK1 über den Zylinderring ZR1 und den Kontakstellen K2 und K4 in radialer Richtung direkt den entsprechenden innenliegenden Endkanten der Waben W21, W23 der Kette WK2 gegenüberliegen. In der gleichen Weise sind die Wabenketten WK2 und WK3 derart zueinander verdreht angeordnet, daß beispielsweise die außenliegenden Endkanten der Waben W21, W22 der Kette WK2 über den Zylinderring ZR2 und den Kontakstellen K5 bzw. K7 in radialer Richtung direkt den entsprechenden innenliegenden Endkanten der Waben W31, W33 der Kette WK3 gegenüberliegen.

Die FIG 2 zeigt schließlich einen besonders vorteilhaften Aufbau des in der FIG 1 dargestellten Ausführungsbeispieles eines erfindungsgemäßen zylinderförmigen Wabenkamins. Jede der Wabenkette WK1 bis WK4 besteht dabei aus zwei ringförmig geschlossenen und versetzt übereinanderliegend miteinander kontaktierten gewellten Wabenstreifen aus leitfähigem Material, insbesondere aus Blech. So besteht beispielsweise die Wabenkette WK1 aus den beiden versetzt übereinanderliegend miteinander kontaktierten, ringförmig geschlossenen, gewellten Wabenstreifen WS11 und WS12. Dabei werden mit dem Wabenstreifen WS11 die innenliegenden, auf das Zentrum des Wabenkamins zulaufenden Hälften der Waben W11 bis W16 der Wabenkette WK1 gebildet. Die außenliegenden, mit dem Zylinderring ZR1 kontaktierten Hälften der Waben dieser Kette werden mit Hilfe des zweiten gewellten Wabenstreifens WS12 gebildet. Zur besseren Übersicht ist die Mittellinie L1 zwischen diesen beiden Wabenstreifen in der FIG 2 strichliert eingetragen. Die beiden Wabenstreifen sind unter anderem an den in der FIG 2 beispielhaft eingetragenen Kontaktstellen K11, K12 elektrisch leitend miteinander verbunden. In der gleichen Weise ist die zwischen den Zylinderringen ZR1 und ZR2 befindliche Wabenkette WK2 vorteilhaft aus den beiden ringförmig geschlossen, gewellten Wabenstreifen WS21 und WS22 aufgebaut. Beide Waben streifen sind beispeilsweise über die Kontakstellen K13 und K14 miteinander elektrisch leitend verbunden. Auch hier ist zur besseren Übersicht die Mittellinie L2 zwischen den Wabenstreifen WS21 und WS22 in der FIG 2 strichliert eingetragen.

Schließlich dienen zum Aufbau der zwischen den Zylinderringen ZR2 und ZR3 angeordneten Wabenketten WK3 und WK4 erfindungsgemäß die Wabenstreifen WS341, WS342, WS343. Da die Wabenketten WK3 und WK4 gemäß der Darstellung von FIG 2 ineinanderliegend verzahnt angeordnet sind und über die gleiche Anzahl an Waben verfügen, können diese vorteilhaft mit Hilfe von drei ringförmig geschlossenen, gewellten Wabenstreifen aufgebaut werden. So bildet der Wabenstreifen WS341 die innenliegenden, mit dem Zylinderring ZR2 kontaktierten Hälften der Waben der Kette WK3. Entsprechend bildet der Streifen WS343 die außenliegenden, mit dem Zylinderring ZR3 kontaktierten Hälften der Waben der Kette WK4. Schließlich bildet der dazwischenliegende Wabenstreifen WS342 sowohl die außenliegenden als auch die innenliegenden Hälften der Waben der Wabenstreifen WK3 bzw. WK4. Auch hier sind zur besseren Übersicht die Mittellinien L3 bzw. L4 zwischen den Wabenstreifen WS341, WS342 bzw. WS342, WS343 strichliert eingetragen.

**Ansprüche**

1. Zylinderförmiger Wabenkamin, insbesondere zum Einsatz in Wänden und Decken von elektromagnetisch abgeschirmten Räumen, Kabinen oder Gebäuden, welcher eine elektromagnetisch abgeschirmte Be- und Entlüftung, Beleuchtung oder Beschallung ermöglicht, wobei kettenartig aneinandergereihte und jeweils einen Hohlraum bildende Waben aus leitfähigem Material ein äußeres Rahmenelement vollständig ausfüllend untereinander und mit dem Rahmenelement elektrisch leitend kontaktiert sind, und wobei die maximal zulässige Wabenbreiten bei Vorliegen einer bestimmten Wabentiefe abhängt vom Wert der gegenüber elektromagnetischen Wellen in einem bestimmten Frequenzbereich gewünschten Dämpfung, **gekennzeichnet** durch ringförmig geschlossene, segmentartig übereinanderliegende Wabenketten (WK1...WK4), welche untereinander und mit einem die Wabenkette nach außen abschließenden zylindrischen Rahmen (ZR3) elektrisch leitend kontaktiert sind, wobei die Anzahl der Waben pro Kette so groß gewählt wird, daß die Breite (WB) der Waben (W11,W21, W31,W41) in den Wabenketten (WK1...WK4) annähernd gleich groß ist.

2. Wabenkamin nach Anspruch 1, **dadurch gekennzeichnet,** daß eine ringförmig geschlossene Wabenkette (WK1) im Inneren des zylindrischen Rahmens (ZR3) mit einem weiteren Zylinderring (ZR1) umgeben und elektrisch leitend kontaktiert ist.

3. Wabenkamin nach Anspruch 2, **dadurch gekennzeichnet,** daß eine auf der Außenseite eines Zylinderringes (ZR2) kontaktierte äußere Wabenkette (WK3) im Vergleich zu der vom Zylinderring (ZR2) umgebenen inneren Wabenkette (WK2) die doppelte Anzahl an Waben (W31...) aufweist.

4. Wabenkamin nach Anspruch 3, **dadurch gekennzeichnet,** daß eine auf der Außenseite eines Zylinderringes (ZR1) kontaktierte äußere Wabenkette (WK2) gegenüber der vom Zylinderring (ZR1) umgebenen inneren Wabenkette (WK1) so verdreht angeordnet ist, daß in radialer Richtung die außenliegende Endkante (WEK) einer jeden Wabe (W11) der inneren Kette (WK1) über den Zylinderring (ZR1) als Kontakstelle (K2) jeweils der innenliegenden Endkante (WEK) einer Wabe (W21) der äußeren Kette (WK2) gegenüberliegt (FIG 1 und 2).

5. Wabenkamin nach einem der vorangegangenen Ansprüche, **dadurch gekennzeichnet,** daß jede Wabenkette (WK2) aus zwei ringförmig geschlossenen und versetzt übereinanderliegend miteinander kontaktierten (K13,K14) gewellten Wabenstreifen (WS21,WS22) aus leitfähigem Material, insbesondere Blech, besteht (FIG 2).

FIG 1

FIG 2